(19) Europäisches Patentamt
European Patent Office
Office européen des brevets

(11) **EP 1 075 086 B1**

(12) **EUROPÄISCHE PATENTSCHRIFT**

(45) Veröffentlichungstag und Bekanntmachung des Hinweises auf die Patenterteilung:
**16.07.2003   Patentblatt 2003/29**

(51) Int Cl.⁷: **H03L 7/089**, G05F 3/22

(21) Anmeldenummer: **00115786.6**

(22) Anmeldetag: **21.07.2000**

(54) **Steuerbare Stromquellenschaltung und hiermit ausgestatteter Phasenregelkreis**

Controlled charge pump circuit and phase locked loop circuit using the charge pump circuit

Source de courant contrôlée et régulateur de phase avec la source de courant contrôlée

(84) Benannte Vertragsstaaten:
**DE FR GB**

(30) Priorität: **23.07.1999  DE 19934723**

(43) Veröffentlichungstag der Anmeldung:
**07.02.2001   Patentblatt 2001/06**

(73) Patentinhaber: **Infineon Technologies AG**
**81669 München (DE)**

(72) Erfinder:
• **Zhang, Xiaopin**
**80805 München (DE)**
• **Herzinger, Stefan**
**80686 München (DE)**
• **Herrmann, Helmut**
**81541 München (DE)**

(74) Vertreter: **Fischer, Volker, Dipl.-Ing. et al**
**Epping Hermann & Fischer**
**Ridlerstrasse 55**
**80339 München (DE)**

(56) Entgegenhaltungen:
**EP-A- 0 777 333**          **US-A- 5 119 043**
**US-A- 5 453 680**          **US-A- 5 465 061**
**US-A- 5 663 686**          **US-A- 5 722 052**
**US-A- 5 770 976**

**Beschreibung**

Die Erfindung betrifft eine Stromquellenschaltung und einen hiermit ausgestatteten Phasenregelkreis, durch den die Phasenlage eines Ausgangssignals auf die Phasenlage eines Referenzsignals, gegebenenfalls mit einem gewünschten Phasenversatz, geregelt wird.

Aus "IEEE Transactions on Communications", Vol. COM-28, No. 11, November 1980: "Charge-Pump Phase-Lock Loops" von F.M. Gardner Seiten 1849 bis 1858, ist der allgemeine Aufbau derartiger Phasenregelkreise bekannt, wobei zwischen die Ausgänge eines Phasendetektors und eines einen Oszillator steuernden, eine Kapazität enthaltenden Schleifenfilters eine Stromquellenschaltung ("Charge-Pump") geschaltet ist, die das Schleifenfilter abhängig vom jeweiligen Phasenvergleichsergebnis mit Strom speist oder Strom vom Schleifenfilter abzieht.

Auch aus "IEEE Journal of Solid-State Circuits": "A 2.7-V GSM RF Transceiver IC", Yamawaki et al, Vol. 32, No. 12, December 1997, Seiten 2089-2096, ist der allgemeine Aufbau solcher Phasenregelkreise bekannt, bei denen das Ausgangssignal des hinsichtlich der Phase zu regelnden Oszillators nach Mischung mit einem lokalen Signal an den Phasenvergleicher angelegt wird, an dessen anderem Eingang ein Referenzsignal in Form eines Zwischenfrequenzsignals anliegt. Zwischen den Ausgang des Phasenvergleichers und das den Oszillator ansteuernde Schleifenfilter ist eine Stromquellenschaltung geschaltet, die in gleicher Weise wie bei der vorstehend diskutierten Druckschrift Transistorschalter enthält, die abhängig von der jeweiligen Phasenlage die Stromspeisung des Schleifenfilters umschalten, so daß die Schleifenfilterkapazität entweder aufgeladen oder entladen wird. Das Schalten der Treibertransistoren (Ladungspumpen) ist jedoch jeweils mit Schaltstörsignalen verbunden, so daß das gesamte Signal/Rauschverhältnis aufgrund der durch die Treibertransistoren ausgeführten Schaltvorgänge verschlechtert ist. Auch ist der benötigte Schaltungsaufwand aufgrund der Schalttransistoren und ihrer Beschaltung recht hoch.

In der US-A-5 663 686 ist eine Ladungspumpenschaltung für einen Phasenregelkreis gezeigt, die ausgangsseitig eine Treiberstufe mit in Reihe geschalteten Transistoren aufweist. Nur einer der Transistoren wird geschaltet, der andere der Transistoren prägt einen Strom ein. Der kontinuierlich betriebene Transistor ist im Ausgangspfad einer Stromspiegelschaltung enthalten. Die Stromquellenschaltung wird zur Ansteuerung eines Schleifenfilters in einem Phasenregelkreis verwendet. Eine ähnliche Stromquellenschaltung ist in der US-A-5 465 061 beschrieben.

In der EP-A-0 777 333 ist eine Ladungspumpenschaltung für einen Phasenregelkreis beschrieben. Die Ladungspumpenschaltung enthält Stromspiegel, die von einem Phasenkomparator angesteuert werden.

In der US-A-5 119 043 ist ein Phasenregelkreis gezeigt, bei dem die Phasenvergleichsschaltung lediglich einen Ausgang aufweist. In der US-A-5 770 976 sind Phasendetektoren beschrieben, die Exclusiv-ODER-Schaltglieder enthalten. Schließlich sind in US-A-5 722 052 und US-A-5 453 680 weitere Ladungspumpenschaltungen gezeigt, die in Phasenregelkreisen verwendet werden können.

Der Erfindung liegt die Aufgabe zugrunde, eine Stromquellenschaltung, insbesondere für einen Phasenregelkreis, zu schaffen, bei der die Anzahl von Schaltvorgängen verringert und damit das Signal/Stör-Verhältnis verbessert ist.

Diese Aufgabe wird mit den im Patentanspruch 1 genannten Merkmalen gelöst. Weiterhin wird eine Verwendung der Stromquellenschaltung in einem Phasenregelkreis gemäß Patentanspruch 8 angegeben. Vorteilhafte Ausgestaltungen der Erfindung sind in den Unteransprüchen angegeben.

Bei der erfindungsgemäßen Stromquellenschaltung ist nur ein einziger, abhängig von einem Steuersignal, z.B. dem Phasenvergleichsergebnis geschalteter Schalter vorgesehen, der entweder eine Aufladung oder eine Entladung der ausgangsseitig angeschlossenen Komponente, z.B. eines Schleifenfilters, bewirkt. Die andere Funktion, d.h. die Entladung oder die Aufladung der Komponente, wird durch einen kontinuierlich eingeschalteten Treibertransistor ausgeführt. Dieser Treibertransistor führt folglich keine Schaltvorgänge aus und erzeugt somit kein Schaltrauschen. Damit ist das insgesamt erzeugte Schaltrauschen verringert und das Signal/Stör-Verhältnis verbessert. Weiterhin ergibt sich der Vorteil, daß die das Steuersignal erzeugende Komponente, z.B. die Phasenvergleichsschaltung nur mit einem einzigen Ausgang ausgestattet sein muß, an den der abhängig vom Steuersignal, z.B. dem Phasenvergleichsergebnis, geschaltete Treiberschalter angeschlossen ist. Damit ist zugleich auch der benötigte Schaltungs- und Verdrahtungsaufwand verringert.

Die kontinuierlich eingeschaltete Treiberstufe ist vorzugsweise derart ausgelegt, daß sie einen Strom führt, der sich von dem von der geschalteten Treiberstufe in deren Einschaltzustand geführten Strom unterscheidet. Damit ergibt sich eine Nettostromdifferenz, die als Vorspannstrom, d.h. Bias-Strom wirkt und zur Frequenzüberstreichung während eines Such- und Einrastvorgangs dient. Hierdurch ist der Schaltungsaufbau noch weiter vereinfacht. Eine noch weitere Vereinfachung läßt sich dadurch erreichen, daß die kontinuierlich eingeschaltete Treiberstufe Teil einer Stromspiegelschaltung ist, in die ein gewünschter Strom eingeprägt wird. Diese Stromspiegelschaltung ist ferner vorzugsweise zusätzlich mit der Phasenvergleichsschaltung verbunden und prägt den Strom in diese ein.

Die Anzahl von insgesamt benötigten Schaltungs- und Steuerkomponenten ist damit reduziert, so daß auch Temperaturdriftprobleme, Anpassungsprobleme (matching) und dergleichen verringert sind. Somit werden gute Schaltungseigenschaften gewährleistet.

Die Erfindung wird nachstehend anhand eines Ausführungsbeispiels unter Bezugnahme auf die Zeichnungen näher erläutert.

Fig. 1      zeigt eine schematische Darstellung eines Phasenregelkreises mit einer erfindungsgemäß ausgelegten Stromquellenschaltung, und

Fig. 2      zeigt ein Blockschaltbild eines Ausführungsbeispiels des erfindungsgemäß ausgelegten Phasenvergleichers.

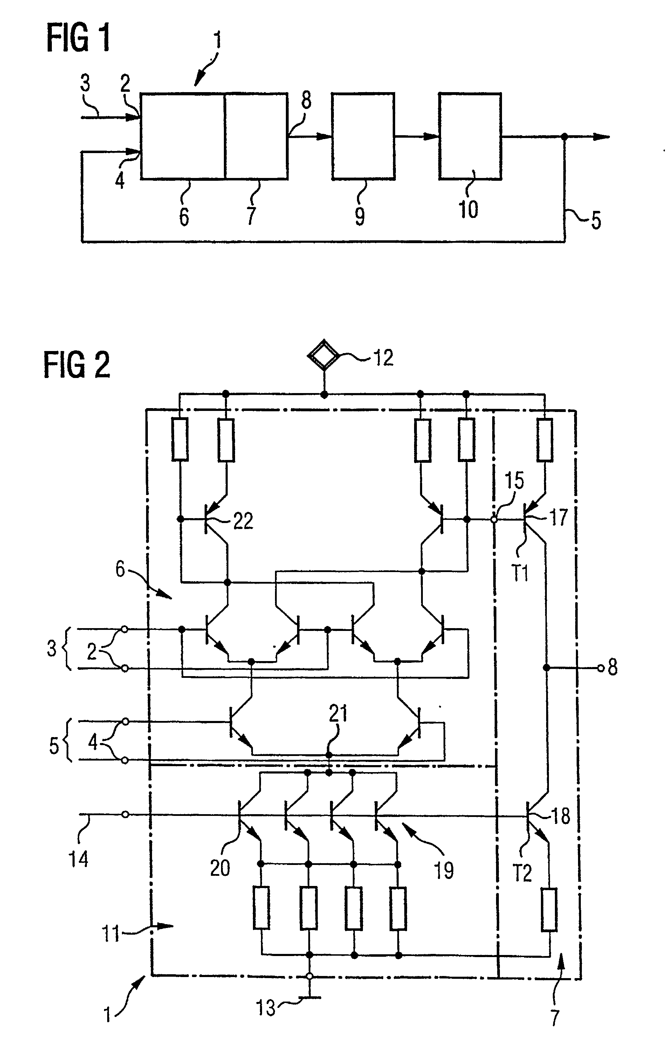

Wie in Fig. 1 gezeigt ist, enthält der Phasenregelkreis einen Phasenvergleicher 1, an dessen einen Eingang 2 ein Referenzsignal 3 angelegt ist. An den anderen Eingang 4 des Phasenvergleichers 1 ist ein hinsichtlich seiner Phasenlage zu regelndes Eingangssignal, hier das ggf. frequenzumgesetzte Ausgangssignal 5 eines spannungsgesteuerten Oszillators 10, angelegt ist. Der Phasenvergleicher 1 umfaßt eine Phasenvergleichsschaltung 6 und eine Stromquellenschaltung 7 (Treiberoder Charge-Pump-Stufe) 7, und gibt über seinen Ausgang 8 das Ausgangssignal an ein Schleifenfilter 9 ab, dessen Kapazität abhängig vom Phasenvergleicher-Ausgangssignal ge- oder entladen wird. Das Schleifenfilter 9 steuert den Oszillator 10, der das phasenstarr auf das Referenzsignal 3 eingeregelte Ausgangssignal 5 erzeugt.

In Fig. 2 ist ein Blockschaltbild des Phasendetektors 1 dargestellt, der drei Funktionsblöcke umfaßt: die Phasenvergleichsstufe 6, die Stromquellenschaltung 7 und eine Stromspiegelschaltung 11. Der Phasenvergleicher 1 ist zwischen einen Versorgungsspannungsanschluß 12 und einen Massepotentialanschluß 13 geschaltet. Die Phasenvergleichsstufe 6 enthält ein zwischen zwei Ausgangszuständen umschaltendes Schaltglied, beispielsweise ein JK-Flipflop oder gemäß Fig. 2 ein Exklusiv-Oder-Glied mit dem gezeigten symmetrischen Aufbau, an dessen Eingangsanschlüsse 2, 4 die beiden miteinander zu vergleichenden Signale 3, 5 über die gezeigten Leitungen angelegt werden und das über die gezeigten Schalttransistoren und Emittergegenkopplungs- sowie Ausräumwiderstände mit dem Versorgungsspannungsanschluß 12 verbunden ist. Die Phasenvergleichsstufe 6 weist nur einen einzigen Ausgang 15 auf, der je nach Phasenlage entweder auf hohes oder auf niedriges Potential umgeschaltet ist. Der eine Schaltzustand entspricht beispielsweise einer Voreilung des Referenzsignals gegenüber dem zu messenden Signal, während der andere Zustand bei nacheilender Phase eingenommen wird.

An den Phasenvergleichsstufenausgang 15 ist die als geschaltete Ladungspumpe ausgebildete Stromquellenschaltung 7 angeschlossen, die einen Schalttransistor 17 umfaßt, dessen Basis mit dem Anschluß 15 verbunden ist und der in durchgeschaltetem Zustand Strom zum Phasenvergleicherausgang 8 speist, so daß die Kapazität des Schleifenfilters 9 aufgeladen wird.

Zur Entladung der Schleifenfilterkapazität enthält die Stromquellenschaltung 7 eine zwischen den Ausgangsanschluß 8 und Massepotential 13 geschaltete, kontinuierlich betriebene Treiberstufe in Form eines Transistors 18, durch den ein konstanter Entladestrom fließt.

Der Transistor 18 kann mit einer eigenen Regelschaltung zur Konstantregelung des durch ihn fließenden Stroms versehen sein, ist vorzugsweise aber Bestandteil einer Stromspiegelschaltung 19 mit mehreren Transistoren 18, 20, deren Basen und Emitter jeweils in an sich bekannter Weise miteinander verbunden sind. Der Basisanschluß der Stromspiegelschaltung 19 ist mit einem Eingangsanschluß 14 verbunden, an den z.B. die Primärseite der Stromspiegelschaltung 19 angeschlossen ist. Hierbei sind der Kollektor und die Basis des primärseitigen Transistors mit dem Anschluß 14 und mit einer Stromquelle verbunden, die den gewünschten Strom einprägt. Der Emitter dieses Transistors ist mit dem Anschluß 13 über einen Emitterwiderstand analog zur Verschaltung der Transistoren 18, 20 verbunden. Die externe Stromspeisung ermöglicht eine einfache Änderung und Justierbarkeit der jeweils in die Stromspiegelschaltung 19 eingeprägten Stromstärke. Selbstverständlich kann die Primärseite der Stromspiegelschaltung auch als Bestandteil der Stromquellenschaltung 7 auf demselben Baustein ausgebildet sein.

Wie aus Fig. 2 ersichtlich ist, sind mehrere Transistoren 20 mit ihren Kollektoren gemeinsam an einen Anschluß 21 der Phasenvergleichsstufe 6 angeschlossen, so daß die Stromspiegelschaltung 19 auch zur Stromsteuerung des im Phasenvergleicher fließenden Stroms dient. Durch die gezeigte Vierfachanordnung der Transistoren 20 wird erreicht, daß in die Phasenvergleichsschaltung 6 ein Strom eingeprägt wird, der viermal so hoch ist wie der durch den Transistor 18 kontinuierlich fließende Entladestrom. Dieser Strom wird auch in die mit dem Ausgang 15 verbundene Ausgangsstufe der Phasenvergleichsschaltung 6 eingeprägt, sofern dieser Zweig aufgrund der aktuellen Phasenlage durchgeschaltet ist. Diese Ausgangsstufe bildet eine Stromspiegelschaltung mit dem Transistor 17, so daß der Transistor 17 im durchgeschalteten Zustand diesen vierfach erhöhten Strom führt und zum Anschluß 8 speist. Von diesem vierfach erhöhten Strom zieht der Transistor 18 ein Viertel ab, so daß effektiv zum Ausgang 8 ein Ladestrom gespeist wird, der dreimal so hoch ist wie der bei ausgeschaltetem Transistor 17 über den Transistor 18 abgeführte Entladestrom.

Die Schaltungsanordnung kann auch derart umgekehrt werden, daß der Transistor 17 kontinuierlich eingeschaltet ist und kontinuierlich Ladestrom zum Schleifenfilter 9 speist. In diesem Fall stellt der Transistor 18 die geschaltete Stromquelle dar, deren Steueranschluß an den Anschluß 15 angeschlossen ist. In diesem Fall ist der Anschluß 15 vorzugsweise mit der Basis des in Fig. 2 gezeigten Transistors 22 verbunden, wohingegen der Transistor 17 einen Teil der Stromspiegelschaltung 19 bildet. Auch in diesem Fall muß die Phasenvergleichsschaltung 6 nur einen einzigen Ausgangsanschluß aufweisen, und es wird nur eine Stromquelle (Transistor) geschaltet, so daß der Schaltungs- und Verdrahtungsaufwand gering ist und das durch die Schaltvorgänge hervorgerufene Schaltrauschen reduziert ist. Ferner wird kein Invertierer zum Invertieren des am Ausgangsanschluß 15 auftretenden Potentials zur Steuerung eines zweiten Transistors benötigt.

Allgemein gilt bei Phasendetektoren, deren Ausgangszustand wie im vorliegenden Fall durch ein Ausgangssignal dargestellt werden kann, daß die Stromspeisung zu dem Schleifenfilter wie folgt ausgedrückt werden kann:

$$I = Q \cdot I_{sc} - (1 - Q) \cdot I_{dc} + I_b.$$

Hierbei bezeichnet Q den Ausgangszustand des Phasendetektors, der entweder 1 oder 0 sein kann; $I_{sc}$ bezeichnet den Source-Ladepumpenstrom, d.h. den Ladestrom; $I_{dc}$ den Drain-Ladepumpenstrom, d.h. den Entladestrom; und $I_b$ einen auf konstanten Wert festgelegten Vorspannstrom. Diese Gleichung läßt sich wie folgt umschreiben:

$$I = Q \cdot (I_{sc} + I_{dc}) + (I_b - I_{dc}).$$

Diese Gleichung belegt, daß bei der Erfindung mit einer einzigen geschalteten Ladungspumpe, die im eingeschalteten Zustand den Strom ($I_{sc} + I_{dc}$) führt, in Kombination mit einer ungeschalteten Konstantstromquelle gearbeitet werden kann, die einen festgelegten konstanten Vorspannstrom ($I_b - I_{dc}$) führt. Hierbei wird ladungstechnisch dasselbe Ergebnis wie bei zwei geschalteten Ladungspumpen mit zusätzlichem Vorspannstrom erreicht. Für das in Fig. 2 gezeigte Ausführungsbeispiel, bei dem der vom Transistor 18 kontinuierlich und konstant geführte Emitterstrom ein Viertel des von der Ladungspumpe 16 bereitgestellten Ladungspumpenstroms ist, ergibt sich für den Stromfluß zu und von dem Schleifenfilter 9 folgendes Ergebnis:

$$I = Q \cdot I_c - I_c/4 = Q \cdot I_c/2 - (1 - Q)I_c/2 + I_c/4.$$

Die gezeigte Schaltung ist somit hinsichtlich der Stromführung äquivalent zu der herkömmlichen Gestaltung, bei der zwei geschaltete Ladungspumpen mit einem Strom von $I_c/2$ und ein zusätzlicher festgelegter konstanter Vorspannstrom $I_c/4$ benutzt werden. Die Funktion dieses Vorspannstroms besteht bekanntlich darin, die Frequenzverstellung während des Such- und Einrastvorgangs zu bewirken.

Bezugszeichenliste

| 1 | Phasenvergleicher |
|---|---|
| 2 | Eingang |
| 3 | Referenzsignal |
| 4 | Eingang |
| 5 | zu regelndes Eingangssignal |
| 6 | Phasenvergleichsschaltung |
| 7 | Stromquellenschaltung |
| 8 | Phasenvergleicherausgang |
| 9 | Schleifenfilter |
| 10 | spannungsgeregelter Oszillator |
| 11 | Stromspiegelschaltung |
| 12 | Versorgungsspannungsanschluß |
| 13 | Massepotentialanschluß |
| 14 | Steueranschluß für Stromspiegelschaltung |
| 15 | Ausgang der Phasenvergleichsschaltung (6) |
| 17 | Schalttransistor |
| 18 | kontinuierlich eingeschaltete Treiberstufe |
| 19 | Stromspiegelschaltung |
| 20 | Transistoren |
| 21 | Stromspeisungsanschluß der Phasenvergleichsschaltung (6) |
| 22 | Schalttransistor |

**Patentansprüche**

1. Steuerbare Stromquellenschaltung, umfassend:

- einen ersten und einen zweiten Anschluß (12, 13) für je ein Versorgungspotential einer Versorgungsspannung;
- eine Treiberstufe (7) mit einem ersten und einem zweiten Transistor (17, 18), die mit ihren geschalteten Strecken in Reihe zwischen die Anschlüsse (12, 13) für die Versorgungspotentiale geschaltet sind;
- einen Ausgangsanschluß (8), der mit dem gegenseitigen Verbindungspunkt der Transistoren (17, 18) der Treiberstufe (7) verbunden ist;
- wobei nur der erste (17) der Transistoren der Treiberstufe (7) ein- und ausgeschaltet wird und der zweite (18) der Transistoren der Treiberstufe (7) eingeschaltet ist und einen eingeprägten Strom führt;
- mindestens zwei in parallel geschalteten Stromzweigen enthaltene weitere Transistoren (20), die an einen Knoten (21) gekoppelt sind und deren Steueranschlüsse gemeinsam mit einem Steueranschluß des zweiten (18) der Transistoren der Treiberstufe (7) verbunden sind;
- eine Phasenvergleichsstufe (6), die zwischen den Knoten (21) und den ersten Anschluß (12) für eines der Versorgungspotentiale geschaltet ist und die einen Stromschalter enthält, der über zwei Strompfade mit dem ersten Anschluß (12) für das eine der Versorgungspotentiale verbunden ist;

- wobei einer der Strompfade eine Primärseite eines Stromspiegels enthält, die sekundärseitig den ersten (17) der Transistoren der Treiberstufe (7) steuert.

2. Steuerbare Stromquellenschaltung nach Anspruch 1,
   **gekennzeichnet durch**
   eine Stromspiegelschaltung (19) mit einer Primärseite und einer Sekundärseite, die die weiteren Transistoren (20) und den zweiten (18) der Transistoren der Treiberstufe (7) enthält, um einen konstanten Strom in den zweiten (18) der Transistoren der Treiberstufe (7) einzuprägen.

3. Steuerbare Stromquellenschaltung nach Anspruch 1 oder 2,
   **dadurch gekennzeichnet, daß**
   der vom ersten (17) der Transistoren der Treiberstufe (7) im eingeschalteten Zustand geführte Strom größer ist als der vom zweiten (18) der Transistoren der Treiberstufe (7) geführte Strom.

4. Steuerbare Stromquellenschaltung nach Anspruch 3,
   **dadurch gekennzeichnet, daß**
   der vom ersten (17) der Transistoren der Treiberstufe (7) im eingeschalteten Zustand geführte Strom um das Vierfache größer ist als der vom zweiten (18) der Transistoren der Treiberstufe (7) geführte Strom.

5. Steuerbare Stromquellenschaltung nach Anspruch 4,
   **dadurch gekennzeichnet, daß**
   vier in parallel geschalteten Stromzweigen enthalte weitere Transistoren (20) vorgesehen sind, deren Steueranschlüsse mit dem Steueranschluß des zweiten (18) der Transistoren der Treiberstufe (7) verbunden sind.

6. Steuerbare Stromquellenschaltung nach einem der Ansprüche 1 bis 5,
   **dadurch gekennzeichnet, daß**
   die Phasenvergleichsstufe (6) nur über einen einzigen Ausgangsanschluß (15) mit der Treiberstufe (7) verbunden ist.

7. Steuerbare Stromquellenschaltung nach einem der Ansprüche 1 bis 6,
   **dadurch gekennzeichnet, daß**
   die Phasenvergleichsstufe (6) ein Exclusiv-ODER-Glied enthält.

8. Verwendung einer steuerbaren Stromquellenschaltung nach einem der Ansprüche 1-7 in einem Phasenregelkreis, der enthält:

- ein Schleifenfilter (9);
- einen steuerbaren Oszillator (10), der vom Schleifenfilter (9) angesteuert wird;
- einen Anschluß für ein Referenzsignal (3);
- bei der das Referenzsignal (3) und ein vom Oszillator erzeugtes Ausgangssignal (5) an Eingangsanschlüssen (2, 4) der Phasenvergleichsstufe (6) der steuerbaren Stromquellenschaltung (1) zugeführt werden.

**Claims**

1. Controllable current source circuit comprising:

- a first and a second connection (12, 13) for a respective supply potential of a supply voltage;
- a driver stage (7) with a first and a second transistor (17, 18), whose switched paths are connected in series between the connections (12, 13) for the supply potentials;
- an output connection (8), which is connected to the opposite junction point of the transistors (17, 18) in the driver stage (7);
- with only the first (17) of the transistors in the driver stage (7) being switched on and off, and the second (18) of the transistors in the driver stage (7) being switched on and carrying a stabilized current;
- at least two further transistors (20), which contain parallel-connected current branches and are coupled at a node (21), and whose control connections are jointly connected to a control connection of the second (18) of the transistors in the driver stage (7);
- a phase comparison stage (6), which is connected between the nodes (21) and the first connection (12) for one of the supply potentials and which contains a current switch which is connected via two current paths to the first connection (12) for one of the supply potentials;
- with one of the current paths containing a primary side of a current mirror which, on the secondary side, controls the first (17) of the transistors in the driver stage (7).

2. Controllable current source circuit according to Claim 1,
   **characterized by**
   a current mirror circuit (19) having a primary side and a secondary side, which contains the further transistors (20) and the second (18) of the transistors in the driver stage (7), in order to force a constant current to flow into the second (18) of the transistors in the driver stage (7).

**3.** Controllable current source circuit according to Claim 1 or 2,
**characterized in that**
the current which is carried by the first (17) of the transistors in the driver stage (7) when it is switched on is greater than the current which is carried by the second (18) of the transistors in the driver stage (7).

**4.** Controllable current source circuit according to Claim 3,
**characterized in that**
the current which is carried by the first (17) of the transistors in the driver stage (7) when it is switched on is four times greater than the current which is carried by the second (18) of the transistors in the driver stage (7).

**5.** Controllable current source circuit according to Claim 4,
**characterized in that**
four further transistors (20) are provided, which are contained in parallel-connected current branches and whose control connections are connected to the control connection of the second (18) of the transistors in the driver stage (7).

**6.** Controllable current source circuit according to one of Claims 1 to 5,
**characterized in that**
the first phase comparison stage (6) is connected to the driver stage (7) via only a single output connection (15).

**7.** Controllable current source circuit according to one of Claims 1 to 6,
**characterized in that**
the phase comparison stage (6) contains an exclusive-OR gate.

**8.** Use of a controllable current source circuit according to one of Claims 1 - 7 in a phase locked loop, which contains:

- a loop filter (9);
- a controllable oscillator (10) which is driven by the loop filter (9);
- a connection for a reference signal (3);
- in which the reference signal (3) and an output signal (5) which is produced by the oscillator are supplied to input connections (2, 4) of the phase comparison stage (6) of the controllable current source circuit (1).

**Revendications**

**1.** Circuit source de courant commandable, comprenant :

- une première et une deuxième borne (12, 13) chacune pour un potentiel d'alimentation d'une tension d'alimentation ;
- un étage d'attaque (7) avec un premier et un deuxième transistor (17, 18) qui sont branchés avec leurs sections commutées en série entre les bornes (12, 13) pour les potentiels d'alimentation ;
- une borne de sortie (8) qui est reliée au point de jonction mutuel des transistors (17, 18) de l'étage d'attaque (7) ;
- seul le premier (17) des transistors de l'étage d'attaque (7) étant commuté conducteur et non conducteur et le deuxième (18) des transistors de l'étage d'attaque (7) étant branché conducteur et conduisant un courant introduit ;
- au moins deux autres transistors (20) qui sont contenus dans des branches de courant branchées en parallèle, qui sont couplés à un noeud (21) et dont les bornes de commande sont reliées en commun à une borne de commande du deuxième (18) des transistors de l'étage d'attaque (7);
- un étage comparateur de phase (6) qui est branché entre les noeuds (21) et la première borne (12) pour l'un des potentiels d'alimentation et qui contient un commutateur de courant qui est relié par l'intermédiaire de deux trajets de courant à la première borne (12) pour l'un des potentiels d'alimentation ;
- l'un des trajets de courant contenant un côté primaire d'un miroir de courant qui commande côté secondaire le premier (17) des transistors de l'étage d'attaque (7).

**2.** Circuit source de courant commandable selon la revendication 1,
**caractérisé par** un circuit miroir de courant (19) avec un côté primaire et un côté secondaire, qui contient les autres transistors (20) et le deuxième (18) des transistors de l'étage d'attaque (7), pour introduire un courant constant dans le deuxième (18) des transistors de l'étage d'attaque (7).

**3.** Circuit source de courant commandable selon la revendication 1 ou 2,
**caractérisé par le fait que** le courant conduit par le premier (17) des transistors de l'étage d'attaque (7) à l'état conducteur est plus grand que le courant conduit par le deuxième (18) des transistors de l'étage d'attaque (7).

**4.** Circuit source de courant commandable selon la revendication 3,

**caractérisé par le fait que** le courant conduit par le premier (17) des transistors de l'étage d'attaque (7) à l'état conducteur est quatre fois plus grand que le courant conduit par le deuxième (18) des transistors de l'étage d'attaque (7).

5. Circuit source de courant commandable selon la revendication 4,

**caractérisé par le fait qu'**il est prévu quatre autres transistors (20) qui sont contenus dans des branches de courant branchées en parallèle et dont les bornes de commande sont reliées à la borne de commande du deuxième (18) des transistors de l'étage d'attaque (7).

6. Circuit source de courant commandable selon l'une des revendications 1 à 5,

**caractérisé par le fait que** l'étage comparateur de phase (6) n'est relié que par l'intermédiaire d'une seule borne de sortie (15) à l'étage d'attaque (7).

7. Circuit source de courant commandable selon l'une des revendications 1 à 6,

**caractérisé par le fait que** l'étage comparateur de phase (6) contient un élément Ou-Exclusif.

8. Utilisation d'un circuit source de courant commandable selon l'une des revendications 1 à 7 dans une boucle à verrouillage de phase qui contient :

- un filtre de boucle (9) ;
- un oscillateur commandable (10) qui est commandé par le filtre de boucle (9);
- une borne pour un signal de référence (3);
- le signal de référence (3) et un signal de sortie (5) produit par l'oscillateur étant envoyés à des bornes d'entrée (2, 4) de l'étage comparateur de phase (6) du circuit source de courant commandable (1).

## FIG 1

## FIG 2